# DEMANDE DE BREVET EUROPEEN

(11) **EP 2 597 774 A1**
(43) Date de publication de la demande: **29.05.2013**
(21) Numéro de dépôt: 12185009.3
(22) Date de dépôt: 19.09.2012
(51) Int. Cl.: H03K 17/96

(54) **Façade tactile de système éléctronique dont les paramètres de fonctionnement sont modifiés par l'intervention physique de l'utilisateur**

(30) Priorité: 21.11.2011 FR 1160604
(71) Demandeur: Atlantic Industrie, 85000 La Roche sur Yon (FR)
(72) Inventeur: Cougnaud, Mathieu, 85000 La Roche sur Yon (FR); Goeury, Sébastien, 85600 Boufféré (FR)
(74) Mandataire: Chaillot, Geneviève

(57) **Abrégé**

La présente invention a pour objet une façade tactile pour système électronique (1), constituée d'une plaque (2) en un matériau électriquement isolant ayant une face (2a) de détection de toucher et/ou de position et une face (2b) opposée à ladite face (2a) de détection de toucher et/ou de position, caractérisée par le fait qu'elle comprend en outre une ou plusieurs pièces conductrices de l'électricité (6), chaque pièce conductrice de l'électricité (6) ayant une extrémité moulée dans l'épaisseur de la plaque (2) en matériau électriquement isolant et faisant saillie de la face (2b) opposée à la face (2a) de détection de toucher et/ou de position depuis ladite extrémité moulée. La présente invention a également pour objet un système électronique (1) comportant ladite façade tactile et un procédé de fabrication de ladite façade tactile.

## Description

L'invention concerne le domaine des systèmes électroniques commandables par un utilisateur, et porte en particulier sur une façade tactile de système électronique dont les paramètres de fonctionnement sont modifiés par l'intervention physique de l'utilisateur. La façade tactile de l'invention permet ainsi de commander les paramètres de fonctionnement de dispositifs électroniques, en particulier une carte électronique du système électronique, notamment par le principe de touche sensitive par effet capacitif. L'invention porte également sur un procédé de fabrication d'une telle façade tactile.

Un système électronique commandable par l'utilisateur comporte de manière générale une ou plusieurs cartes électroniques commandant le fonctionnement de ce système électronique. Pour une utilisation conviviale et en toute sécurité d'un système électronique commandable par l'utilisateur, la ou les cartes électroniques du système ne sont pas directement accessibles par l'utilisateur et sont protégées dans un boîtier. L'utilisateur interagit alors avec la ou les cartes électroniques du système électronique par l'intermédiaire d'une interface de commande, souvent en face avant (appelée ci-après façade) dudit boîtier.

Il est alors nécessaire de détecter et de transmettre une information entrée de manière tactile par l'utilisateur sur la façade, depuis ladite façade jusqu'à la carte électronique.

Il existe à l'heure actuelle plusieurs types d'interface entre une façade de système électronique et une carte électronique de ce même système électronique.

Une première solution consiste à avoir des pièces mécaniques en mouvement en façade du système électronique, lesdites pièces mécaniques étant mises en mouvement par un toucher de l'utilisateur. Le toucher est alors détecté de manière mécanique et transmis à la carte électronique.

Cette première solution présente des inconvénients. Tout d'abord, les pièces mécaniques peuvent s'user, ce qui peut poser des problèmes de fiabilité. Ensuite, cette solution nécessite l'approvisionnement en pièces mécaniques et impose de nombreuses étapes d'assemblage, ce qui rend cette première solution potentiellement complexe pour la production en grande série de systèmes électroniques commandables par l'utilisateur. De plus, cette solution ne permet pas d'assurer simplement l'étanchéité de la façade. Enfin, cette solution impose des pièces mécaniques d'interface parfois complexes pour transmettre de façon confortable l'appui de l'utilisateur à la carte électronique.

Une autre solution consiste à utiliser un principe de touche sensitive par effet capacitif, dans lequel le toucher d'un utilisateur sur une façade est détecté par une pièce conductrice en contact avec la façade, la pièce conductrice transmettant ensuite par transmission électrique le toucher à la carte électronique. La pièce conductrice est maintenue en place dans le système électronique en étant associée, par exemple par bouterollage, à une pièce en matière plastique.

Cette deuxième solution présente les inconvénients suivants :
- mauvais maintien des deux pièces conductrice et en matière plastique, en raison du procédé d'association par bouterollage ;
- mauvaise capabilité du procédé, c'est-à-dire que celui-ci est difficilement applicable à une production en grande série ;
- introduction d'une étape dans le procédé de fabrication du système électronique pour assembler les deux pièces par bouterollage ;
- présence potentielle d'air entre les deux pièces assemblées, qui diminue la sensibilité de la détection d'appui par effet capacitif ;
- perte de surface sur la pièce métallique, en raison du procédé de bouterollage, ce qui diminue la sensibilité de la détection d'appui par effet capacitif.

La demande de brevet européen EP2003778 A2 décrit une façade tactile dans laquelle une pièce conductrice est moulée dans la façade, avec un espace entre l'extrémité de la pièce destinée à coopérer avec des circuits de détection sur une carte électronique et lesdits circuits de détection sur ladite carte électronique.

La façade tactile divulguée dans la demande EP2003778 A2 ne permet pas de garantir une bonne détection de toucher et une absorption des tolérances d'assemblage.

La demande de brevet américain US200/285872 décrit des éléments conducteurs fixés sur une façade tactile.

La demande de brevet français FR2183712 A1 décrit un interrupteur dont une surface d'effleurement est constituée par une plaque assemblée sur la surface supérieure de la surface d'effleurement.

La demande de brevet européen EP2355117 A1 décrit un boîtier entourant une carte électronique, à travers une surface duquel passe une pièce conductrice reposant sur la surface inférieure d'une surface d'effleurement.

La demande de brevet européen EP1732224 A1 décrit une interface tactile avec des pièces conductrices comportant au moins une fente.

Aucun des documents de l'état antérieur ci-dessus ne décrit une interface tactile permettant à la fois une détection de toucher fiable et une bonne absorption des tolérances d'assemblage, avec une structure simple.

Il est donc nécessaire de proposer une façade tactile de structure simple pour un système électronique, permettant d'avoir une bonne détection d'un toucher d'utilisateur en façade, et une bonne transmission électrique de la détection du toucher jusqu'aux dispositifs électroniques du système électronique. Il est également nécessaire d'améliorer le procédé de fabrication d'une façade tactile de système électronique, afin d'obtenir un système électronique dans lequel une information entrée par l'utilisateur depuis la façade tactile est détectée et transmise jusqu'aux dispositifs électroniques du système électronique (circuit électronique de traitement du système électronique) de manière robuste, avec un procédé d'assemblage facilité, dans lequel les étapes de soudures ou analogues des procédés existants sont supprimées et sans autre interface mécanique entre la façade et les dispositifs électroniques.

Le procédé devra notamment permettre de relier électriquement de manière fiable les dispositifs électroniques à la façade tactile touchée par l'utilisateur et d'absorber les tolérances mécaniques des différents assemblages.

L'invention vise donc à proposer une façade tactile de système électronique de structure simple pour un système électronique dont les paramètres de fonctionnement sont modifiés par l'intervention physique de l'utilisateur, le système électronique comportant au moins une carte électronique ou plus généralement des dispositifs électroniques. La façade tactile de système électronique selon l'invention est facile à incorporer dans le système électronique au moment de sa fabrication, et présente une bonne transmission électrique permettant de transmettre à la carte électronique ou aux dispositifs électroniques l'information entrée sur la façade de manière tactile par l'utilisateur.

L'invention vise également à proposer un procédé de fabrication simple et applicable à une production en grande série d'une telle façade tactile pour système électronique.

L'invention porte sur une façade tactile de système électronique comprenant une carte électronique, ladite façade étant constituée :
- d'une pièce en matière électriquement isolante ; et
- d'une interface mécanique conductrice de système électronique, cette interface mécanique conductrice étant constituée par une pièce électriquement conductrice, fixée à la pièce en matière électriquement isolante par moulage.

La pièce électriquement conductrice, en contact électrique avec la carte électronique une fois le système électronique assemblé, permet la détection de toucher par le principe de touche sensitive par effet capacitif.

Avec cette pièce conductrice fixée à la façade tactile par moulage, la façade tactile est reliée électriquement à la carte électronique sans autre pièce mécanique d'interface. Il n'y a donc pas d'usure de pièces et le système présente une durée de vie prolongée par rapport aux systèmes de l'état antérieur de la technique.

La pièce électriquement conductrice étant moulée dans la façade tactile, il n'y a pas de présence d'air entre la pièce électriquement conductrice et la façade tactile, et la pièce électriquement conductrice est bien maintenue dans la façade tactile. L'effet capacitif lors d'un toucher d'utilisateur est ainsi accru.

Avantageusement, la forme de la pièce électriquement conductrice peut être adaptée pour permettre une absorption des tolérances d'assemblage entre la façade tactile et la carte électronique de traitement, notamment par effet ressort. Elle est ainsi sollicitée en contact électrique, lorsque le système électronique est assemblé, contre la carte électronique. De préférence, la pièce conductrice a la forme d'un J, la partie supérieure du J étant moulée dans l'épaisseur de la façade tactile, le jambage du J étant en saillie de la façade. La partie inférieure du J, arrondie, est sollicitée contre la carte électronique pour garantir un bon contact électrique entre la pièce conductrice et la carte électronique.

Le procédé d'assemblage, consistant à mouler la pièce électriquement conductrice dans la façade, peut être répété et est donc applicable à une production en grande série. Il présente également l'avantage d'avoir une unique étape de moulage d'une ou plusieurs pièces électriquement conductrices, sans étape supplémentaire pour associer la ou les pièces électriquement conductrices à la façade. Ceci permet notamment de positionner simultanément toutes les pièces conductrices par rapport à la façade tactile, à l'aide d'une machine.

Cette façade tactile et ce procédé présentent de plus l'avantage d'imposer peu de contraintes sur la position, la forme et le nombre de pièces électriquement conductrices, la fixation par moulage à la façade de la ou des pièces électriquement conductrices permettant une grande liberté de positionnement, de forme et de nombre de pièces électriquement conductrices positionnables dans la façade. Les pièces conductrices peuvent de plus être positionnées simultanément lors du moulage, et non pas une par une, ce qui réduit le temps de fabrication.

La façade proposée et son procédé de fabrication correspondant permettent donc d'adapter les positions, formes et nombres de pièces électriquement conductrices dans la façade pour détecter efficacement la position d'un appui (ou toucher). Cette détection est applicable à titre d'exemple à un système à touches capacitives.

Enfin, grâce à la façade tactile de l'invention, l'étanchéité de la façade est assurée d'une manière simple, et il n'est pas nécessaire d'avoir de pièces mécaniques complexes pour transmettre de manière confortable l'appui de l'utilisateur à la carte électronique.

La façade tactile et la carte électronique qu'elle commande peuvent être parallèles ou former un angle. Facultativement, comme indiqué ci-dessus, la pièce conductrice a une forme qui lui permet d'être sollicitée contre la carte électronique pour un meilleur contact électrique avec celle-ci lorsque le système électronique complet est assemblé.

La présente invention a donc pour objet une façade tactile pour système électronique, constituée d'une plaque en un matériau électriquement isolant ayant une face de détection de toucher et/ou de position et une face opposée à ladite face de détection de toucher et/ou de position, caractérisée par le fait qu'elle comprend en outre une ou plusieurs pièces conductrices de l'électricité, chaque pièce conductrice de l'électricité ayant une extrémité moulée dans l'épaisseur de la plaque en matériau électriquement isolant et faisant saillie de la face opposée à la face de détection de toucher et/ou de position depuis ladite extrémité moulée.

De préférence, chaque pièce conductrice a une partie moulée dans l'épaisseur de la plaque en matériau électriquement isolant de telle sorte qu'aucune partie de la pièce conductrice n'est en saillie sur la face de détection de toucher et/ou de position.

La présence d'air entre la plaque en un matériau électriquement isolant constituant la façade et la ou les pièces conductrices de l'électricité est ainsi rendue minimale. L'effet capacitif lors d'un toucher d'utilisateur sur la façade est amélioré.

Selon une caractéristique particulière, la partie en saillie de chaque pièce conductrice de l'électricité peut être déformable par effet ressort. Elle est ainsi apte à être sollicitée contre une zone de détection de charge électrique pour améliorer une détection de charge électrique lors d'un toucher d'utilisateur sur la façade tactile.

Chaque pièce conductrice de l'électricité peut être constituée par un élément quelconque parmi une lame métallique, un élastomère chargé, un plastique chargé ou une tresse métallique.

Le matériau électriquement isolant constituant la plaque peut être du verre ou une matière plastique isolante apte à être moulée, de préférence du polycarbonate.

La plaque en un matériau électriquement isolant peut facultativement être transparente, par exemple pour la disposition sous celle-ci d'un écran à cristaux liquides.

L'invention a également pour objet un système électronique à détection de toucher par effet capacitif, constitué d'un boîtier comprenant une carte électronique comportant un ou des circuits de détection de toucher et/ou de position, caractérisé par le fait qu'au moins l'une des faces du boîtier est constituée au moins en partie par une façade tactile telle que définie ci-dessus, comportant des pièces conductrices de l'électricité moulées dans celle-ci de façon à ce que, lorsque le système électronique est assemblé, la partie en saillie de chaque pièce conductrice de l'électricité soit en contact avec un circuit de détection de toucher et/ou de position de la carte électronique, de telle sorte que lorsqu'un utilisateur touche la face de détection de toucher et/ou de position de la façade tactile à un emplacement sur celle-ci où est moulée une extrémité d'une pièce conductrice de l'électricité, un échange de charges électriques est permis par la pièce conductrice de l'électricité pour permettre une détection par effet capacitif par le circuit de détection de toucher et/ou de position pour une détection de toucher et/ou de position.

Avantageusement, chaque pièce conductrice de l'électricité peut être agencée pour être sollicitée en contact avec le circuit de détection de toucher et/ou de position correspondant de la carte électronique pour améliorer la détection de toucher et/ou de position.

Selon une caractéristique particulière, pour chaque pièce conductrice de l'électricité reliant la façade tactile aux circuits de détection de toucher et/ou de position de ladite carte électronique, la longueur de la partie en saillie est supérieure à la distance séparant la face opposée à la face de détection de toucher et/ou de position de la façade tactile et la face de ladite carte électronique portant lesdits circuits de détection de toucher et/ou de position, ladite distance étant mesurée à la verticale de l'emplacement d'où fait saillie de la face opposée à la face de détection de toucher la pièce conductrice considérée. La pièce conductrice est ainsi toujours sollicitée contre la carte électronique lorsque le système électronique est assemblé.

L'invention a également pour objet un procédé de fabrication d'une façade tactile telle que définie ci-dessus, caractérisé par le fait qu'il comprend l'étape de moulage d'une plaque en un matériau électriquement isolant avec inserts d'une ou plusieurs pièces conductrices de l'électricité, facultativement positionnées simultanément.

Pour mieux illustrer l'objet de la présente invention, on va en décrire ci-après un mode de réalisation préféré avec référence aux dessins annexés.

Sur ces dessins :
- la Figure 1 est une vue schématique en coupe d'un système électronique assemblé, comportant une façade tactile selon la présente invention ;
- la Figure 2 est une vue en éclaté du système électronique de la Figure 1 ; et
- la Figure 3 est une vue schématique illustrant le positionnement de la façade tactile sur une carte électronique.

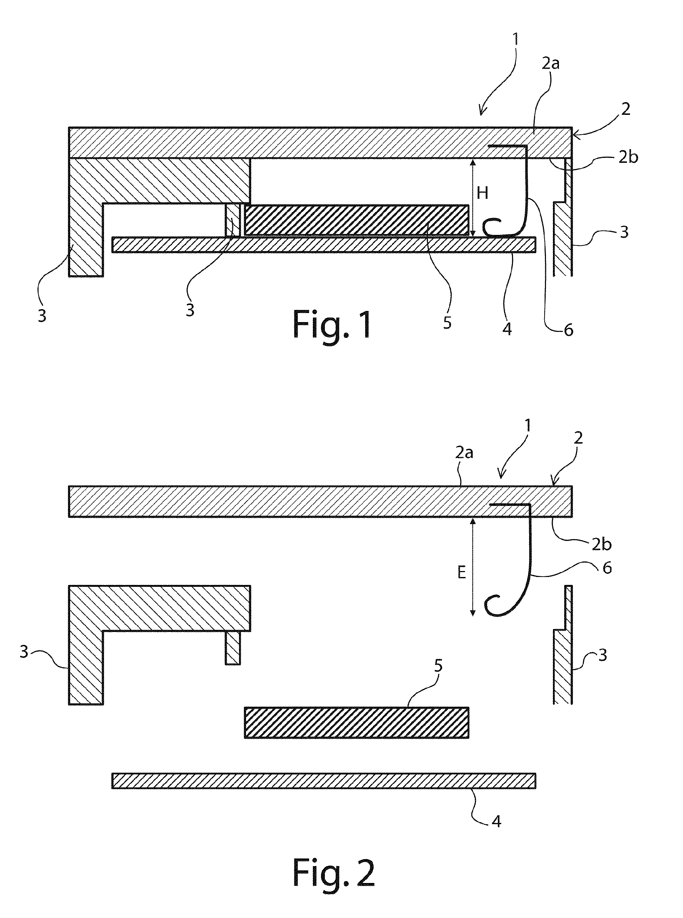

Si l'on se réfère aux Figures 1 et 2, on peut voir qu'il y est représenté un système électronique 1 comprenant une plaque en matériau électriquement isolant 2, un boîtier 3 supportant la plaque 2 et une carte électronique 4 placée à l'intérieur du boîtier 3.

La plaque 2 en un matériau électriquement isolant, facultativement transparent, par exemple du verre ou du polycarbonate, présente une face externe 2a de détection de toucher et/ou de position et une face interne 2b. Dans le mode de réalisation représenté sur les Figures 1 et 2, la plaque 2 est transparente, et un écran à cristaux liquides 5, relié de manière fonctionnelle à la carte électronique 4, est positionné entre la plaque 2 et la carte électronique 4 et permet de transmettre visuellement des informations à l'utilisateur.

Cet écran à cristaux liquides 5 est toutefois facultatif, et sa présence dépend de l'utilisation du système électronique.

Au moins une pièce conductrice de l'électricité 6 a une partie (extrémité supérieure sur les Figures 1 et 2) moulée dans l'épaisseur de la plaque 2 et fait saillie depuis la face interne 2b de la plaque 2. L'ensemble plaque 2 et pièce conductrice 6 constitue la façade tactile de l'invention.

La pièce conductrice 6 est en matériau déformable par effet ressort, par exemple une lame métallique, un élastomère chargé, un plastique chargé ou une tresse métallique. Elle a sensiblement la forme d'un J, la partie supérieure du J étant moulée dans la plaque 2, et la partie inférieure ou jambage du J étant en saillie de la plaque 2.

Si l'on définit l'extension E de la partie en saillie de la pièce conductrice 6 comme étant la distance, lorsque le système électronique 1 n'est pas assemblé comme représenté sur la Figure 2, entre la face interne 2b de la plaque 2 et le point de la pièce conductrice 6 le plus éloigné de la face interne 2b dans une direction orthogonale à la surface de la face interne 2b, et la distance H comme étant la distance, lorsque le système électronique est assemblé comme représenté sur la Figure 1, séparant la face interne 2b de la plaque 2 et la carte électronique 4, alors la relation E > H est satisfaite, de telle sorte que la partie en saillie de la pièce conductrice 6 est sollicitée contre la carte électronique 4 lorsque le système électronique 1 est assemblé.

La forme de J pour la pièce conductrice 6 a été représentée dans le mode de réalisation, mais toute forme de pièce conductrice 6 permettant une sollicitation de la partie en saillie de la pièce conductrice 6 contre la carte électronique peut être envisagée, par exemple une forme de Z.

Sur les Figures 1 et 2, on a représenté schématiquement une unique pièce conductrice 6 moulée dans la plaque 2, pour ne pas surcharger le dessin.

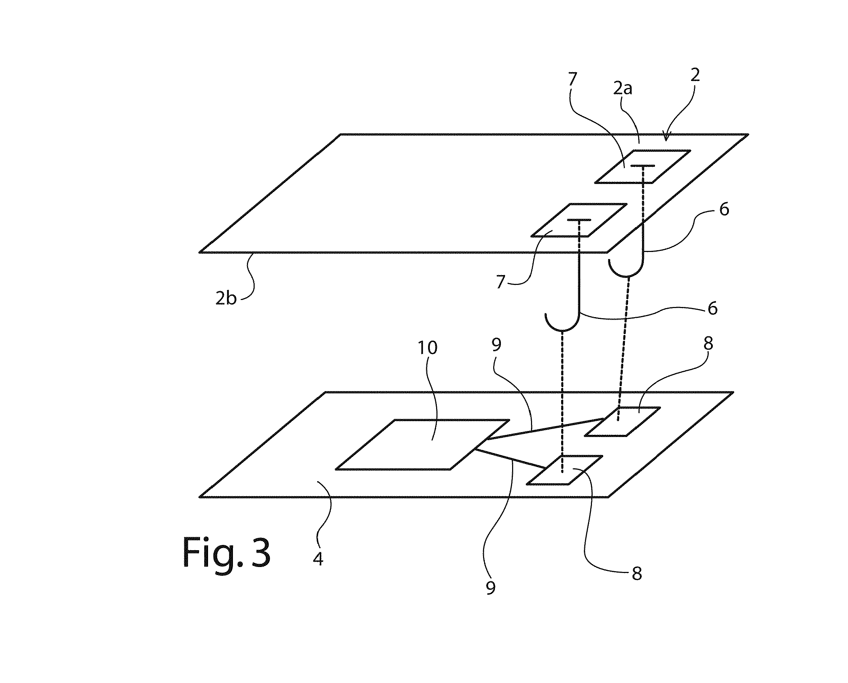

Il est évident que l'on peut mouler dans la plaque 2 plus d'une pièce conductrice 6, comme cela est représenté sur la Figure 3 où deux pièces conductrices 6 sont moulées dans la plaque 2.

Les pièces conductrices 6 sont moulées de manière classique par moulage par insert dans la plaque 2. Le moulage par insert permet notamment un positionnement précis des pièces conductrices 6 sur la façade tactile.

Comme on peut le voir sur la Figure 3, il est défini sur la face de détection de toucher et/ou de position 2a de la plaque 2 des zones 7 de détection de toucher, chaque zone 7 de détection de toucher correspondant à une pièce conductrice 6 respective et étant définie comme étant la surface que peut toucher un utilisateur pour être détecté par effet capacitif dans cette pièce conductrice 6.

Lors de l'assemblage de la façade tactile dans le système électronique, représenté schématiquement sur la Figure 3, les parties en saillie des pièces conductrices 6 entrent en contact avec des surfaces de détection 8 sur la carte électronique 4, lesdites surfaces de détection 8 étant connectées électriquement par l'intermédiaire de pistes conductrices 9 à une puce de détection de toucher et/ou de position 10, représentée schématiquement sur la carte électronique 4.

Ainsi, lorsque l'utilisateur touche l'une des zones 7 de détection de toucher, il modifie la capacité formée par l'ensemble 'utilisateur - pièce conductrice 6 - surface de détection 8 - pistes conductrices 9 / masse du circuit', modification détectée par la puce de détection de toucher et/ou position 10 pour un traitement par la carte électronique 4 (sur laquelle les autres circuits nécessaires ne sont pas représentés). La pièce conductrice 6 est nécessaire pour permettre l'augmentation de l'influence de l'utilisateur sur la modification de la capacité pour la rendre détectable par la puce de détection de toucher et/ou de position 10, dans le cas où les zones 7 de détection sont éloignées des surfaces de détection 8 associées. Les éléments 8, 9 et 10 constituent conjointement un circuit de détection de toucher et/ou de position.

Il est à noter que l'on peut mouler autant de pièces conductrices 6 dans la plaque 2 qu'il est nécessaire. Celles-ci sont alors positionnées dans le moule pour un moulage par insert classique, aux positions correspondant aux surfaces de détection sur la carte électronique 4. Les différentes pièces conductrices peuvent notamment avantageusement être placées simultanément dans le moule par une machine. Il est à noter également que la position et le nombre de pièces conductrices peuvent être tels qu'une détection de position puisse être possible.

On peut également noter qu'il est possible que la façade tactile de l'invention soit sur les côtés du boîtier, c'est-à-dire que la façade tactile soit perpendiculaire à la carte électronique, ou plus généralement inclinée par rapport à celle-ci, sans s'écarter de la portée de l'invention. La ou les différentes pièces conductrices présentent dans ce cas une partie moulée dans l'épaisseur de la façade tactile, et une partie en saillie, facultativement sollicitée contre une surface de détection de la carte électronique, de manière analogue au mode de réalisation décrit dans les Figures.

Le mode de réalisation décrit comprend une carte électronique. Il apparaîtra cependant à l'homme du métier qu'une même façade tactile peut commander plusieurs cartes électroniques dans le système électronique.

## Revendications

1. Façade tactile pour système électronique (1), constituée d'une plaque (2) en un matériau électriquement isolant ayant une face (2a) de détection de toucher et/ou de position et une face (2b) opposée à ladite face (2a) de détection de toucher et/ou de position, comprenant en outre une ou plusieurs pièces conductrices de l'électricité (6), chaque pièce conductrice de l'électricité (6) ayant une extrémité moulée dans l'épaisseur de la plaque (2) en matériau électriquement isolant et faisant saillie de la face (2b) opposée à la face (2a) de détection de toucher et/ou de position depuis ladite extrémité moulée, **caractérisée par le fait que** la partie en saillie de chaque pièce conductrice de l'électricité (6) est déformable par effet ressort.

2. Façade tactile pour système électronique (1) selon la revendication 1, **caractérisée par le fait que** chaque pièce conductrice de l'électricité (6) est constituée par un élément quelconque parmi une lame métallique, un élastomère chargé, un plastique chargé ou une tresse métallique.

3. Façade tactile pour système électronique (1) selon l'une des revendications 1 à 2, **caractérisée par le fait que** le matériau électriquement isolant constituant la plaque (2) est du verre ou une matière plastique isolante apte à être moulée, de préférence du polycarbonate.

4. Façade tactile pour système électronique (1) selon l'une des revendications 1 à 3, **caractérisée par le fait que** la plaque (2) en un matériau électriquement isolant est transparente.

5. Système électronique (1) à détection de toucher par effet capacitif, constitué d'un boîtier (3) comprenant une carte électronique (4) comportant un ou des circuits (8, 9, 10) de détection de toucher et/ou de position, **caractérisé par le fait qu'**au moins l'une des faces du boîtier (3) est constituée au moins en partie par une façade tactile selon l'une des revendications 1 à 4, comportant des pièces conductrices de l'électricité (6) moulées dans celle-ci de façon à ce que, lorsque le système électronique (1) est assemblé, la partie en saillie de chaque pièce conductrice de l'électricité (6) soit en contact avec un circuit (8, 9, 10) de détection de toucher et/ou de position de la carte électronique (4), de telle sorte que lorsqu'un utilisateur touche la face (2a) de détection de toucher et/ou de position de la façade tactile à un emplacement sur celle-ci où est moulée une extrémité d'une pièce conductrice de l'électricité (6), un échange de charges électriques est permis par la pièce conductrice de l'électricité (6) pour permettre une détection par effet capacitif par le circuit (8, 9, 10) de détection de toucher et/ou de position pour une détection du toucher et/ou de position.

6. Système électronique (1) selon la revendication 5, comprenant une façade tactile selon l'une des revendications 1 à 4, **caractérisé par le fait que** chaque pièce conductrice de l'électricité (6) est agencée pour être sollicitée en contact avec le circuit (8, 9, 10) de détection de toucher et/ou de position correspondant de la carte électronique (4).

7. Système électronique (1) selon la revendication 6, **caractérisé par le fait que**, pour chaque pièce conductrice de l'électricité (6) reliant la façade tactile aux circuits (8, 9, 10) de détection de toucher et/ou de position de ladite carte électronique (4), la longueur de la partie en saillie est supérieure à la distance séparant la face (2b) opposée à la face (2a) de détection de toucher et/ou de position de la façade tactile et la face de ladite carte électronique (4) portant lesdits circuits (8, 9, 10) de détection de toucher et/ou de position, ladite distance étant mesurée à la verticale de l'emplacement d'où fait saillie de la face (2b) la pièce conductrice (6) considérée.

8. Procédé de fabrication d'une façade tactile selon l'une des revendications 1 à 4, **caractérisé par le fait qu'**il comprend l'étape de moulage d'une plaque (2) en un matériau électriquement isolant avec inserts d'une ou plusieurs pièces conductrices de l'électricité (6), facultativement positionnées simultanément.
